# EUROPÄISCHE PATENTSCHRIFT

(11) **EP 2 089 145 B1**
(45) Veröffentlichungstag und Bekanntmachung des Hinweises auf die Patenterteilung: **18.08.2010**
(21) Anmeldenummer: 07818962.8
(22) Anmeldetag: 12.10.2007
(51) Int. Cl.: B01J 3/00, B01J 3/03, C23C 14/56

(54) **BANDSCHLEUSE**
STRIP SEALING GATE
JOINT POUR BANDE

(30) Priorität: 27.10.2006 DE 102006051396; 28.02.2007 DE 102007009678
(43) Veröffentlichungstag der Anmeldung: 19.08.2009
(73) Patentinhaber: SMS Siemag AG, 40237 Düsseldorf (DE)
(72) Erfinder: KÜMMEL, Lutz, 41363 Jüchen (DE); GRAMER, Andreas, 42655 Solingen (DE); BEHRENS, Holger, 40699 Erkrath (DE); KRETSCHMER, Matthias, 50939 Köln (DE); SOHL, Ralf-Hartmut, 42699 Solingen (DE); DE KOCK, Peter, 46117 Oberhausen (DE)
(74) Vertreter: Klüppel, Walter
(86) Internationale Anmeldenummer: PCT/EP2007/008891
(87) Internationale Veröffentlichungsnummer: WO 2008/049524

(56) Entgegenhaltungen:
- DE-A1- 4 418 383
- DE-A1- 19 960 751
- DE-C1- 4 240 490

## Beschreibung

Die Erfindung betrifft eine Bandschleuse zur Abdichtung eines ersten Raumes gegenüber einem zweiten Raum, wobei beide Räume von einem Band, insbesondere einem Metallband, passiert werden, wobei zur Abdichtung der Räume mindestens zwei Rollen vorgesehen sind, die sich beidseitig des Bandes dichtend an dieses anlegen.

Bei der Herstellung und Veredelung eines Metallbandes, insbesondere eines Stahlbandes, ist es gelegentlich erforderlich, Prozesse in druckreduzierter Umgebung vorzunehmen (Vakuumprozess). Hierzu wird das Band in einen Raum geführt, der ein gegenüber dem Umgebungsdruck abgesenktes Druckniveau aufweist. Um einen kontinuierlichen Prozess zu erreichen, sind hierfür Bandschleusen der genannten Art notwendig, die das Band zwischen den Räumen unterschiedlichen Druckniveaus abdichten. Die Schleusen dienen also primär zum Aufbau einer Druckdifferenz zwischen zwei Bandbehandlungsbereichen.

Gattungsgemäße Bandschleusen sind beispielsweise aus der DE 44 18 383 C2 und aus der DE 199 60 751 A1 bekannt. Dort ist beschrieben, dass sich an einer Schleusenstufe zwei Abdichtrollen an das Band anlegen, um es abzudichten, und zwar eine erste Abdichtrolle auf der Oberseite und eine zweite Abdichtrolle auf der Unterseite des Bandes. Um die Dichtigkeit der Schleusenstufe zu verbessern, sind dabei die zylindrisch ausgebildeten Walzen an ihrem Umfang mit einem Mantel aus elastischem, flexiblem Material umhüllt. Der Mantel kann sich dichtend an die Bandoberfläche anlegen und so die Dichtigkeit der Schleuse erhöhen.

Derartige Bandschleusen kommen generell für Produkte mit einem Breiten- zu Dickenverhältnis von wesentlich größer als 1 zum Einsatz. Sie können auch eingesetzt werden, um Kammern gegeneinander abzudichten, in denen unterschiedliche Medien zur Bandbehandlung eingesetzt werden.

Die genannten vorbekannten Lösungen arbeiten dabei nicht immer voll zufriedenstellend. Dies gilt insbesondere, wenn sich chargenbedingt die Breite des abzudichtenden Bandes ändert. Die Anpassung der Bandschleuse auf Bänder unterschiedlicher Breite ist aufwändig und zeitigt nicht immer ein gutes Dichtungsergebnis.

Der vorliegenden Erfindung liegt daher die Aufgabe zugrunde, eine Bandschleuse der eingangs genannten Art so weiterzubilden, dass diesbezüglich eine Verbesserung erreicht werden kann. Die Schleuse soll also eine verbesserte Dichtwirkung aufweisen und universell für Bänder unterschiedlicher Breite einsetzbar sein.

Die Lösung dieser Aufgabe durch die Erfindung ist **dadurch gekennzeichnet, dass** mindestens eine der Rollen an ihrem Umfang zumindest abschnittsweise mit einem flexiblen, elastischen Material versehen ist, wobei die mindestens eine Rolle einen inneren Kern aufweist, der mit einem Mantel aus dem flexiblen, elastischen Material versehen ist, wobei der innere Kern in einem Mittenbereich eine zylindrische Kontur aufweist und wobei der Kern in seinen Randbereichen aufgeweitet ist.

Hiermit wird es möglich, die Abdichtfähigkeit der Rollen im kritischen Bereich der Bandkanten wesentlich zu verbessern.

Bevorzugt besteht der Kern aus zwei Teilen, die in Achsrichtung zueinander verschiebbar sind. Damit kann in einfacher Weise die Bandschleuse an Bänder unterschiedlicher Breite eingestellt werden.

Eine der zusammenwirkenden Rollen kann eine über die gesamte axiale Erstreckung durchgängige zylindrische Kontur mit konstantem Durchmesser aufweisen. Dabei kann die Oberfläche der mit durchgängig zylindrischer Kontur versehenen Rolle aus Stahl bestehen. Es kann aber auch vorgesehen sein, dass die mit durchgängig zylindrischer Kontur versehene Rolle mit flexiblem, elastischem Material versehen ist.

Alternativ und bevorzugt ist vorgesehen, daß beide zusammenwirkenden Rollen den inneren Kern mit der in den Randbereichen aufgeweiteten Kontur aufweisen.

Die beiden zueinander axial verschieblichen Teile des Kerns können in ihrem Berührungsbereich eine zueinander komplementäre Querschnittsform haben.

Die mindestens eine Rolle kann weiterhin über ihre gesamte axiale Erstreckung mit dem Mantel aus flexiblem, elastischem Material versehen sein. Eine Alternative hierzu sieht vor, dass die mindestens eine Rolle nur in ihren axialen Randbereichen mit einem Mantel aus flexiblem, elastischem Material versehen ist.

Zur effizienten Rückraumabdichtung kann vorgesehen werden, dass die mindestens eine Rolle an mindestens einer Abdichtrolle anläuft, die auf derselben Bandseite angeordnet ist. Die Abdichtrolle kann dabei an einer weiteren Abdichtrolle anlaufen. Zumindest eine der Abdichtrollen kann dabei an einer Dichtfläche anlaufen. Dabei ist bevorzugt vorgesehen, dass die Dichtfläche konkav ausgebildet ist, insbesondere der Form der sie kontaktierenden Abdichtrolle angepasst ist.

Im axialen Endbereich der mindestens einen Rolle kann ein Dichtelement angeordnet sein, das die Stirnseite der mindestens einen Rolle kontaktiert. Das Dichtelement kann dabei so angeordnet sein, dass es mittels eines Federelements in axiale Richtung elastisch vorgespannt an der Stirnseite der mindestens einen Rolle anliegt.

Im axialen Endbereich der mindestens einen Rolle kann weiterhin ein Dichtelement angeordnet sein, das über eine seitliche, an der Bandkante anlaufende Führungsrolle auf einem definierten Spaltabstand zur Bandkante gehalten wird. Hiermit ist der Verschleiß des Dichtelements wesentlich herabsetzbar.

Um höhere Druckdifferenzen aufzubauen, hat es sich bewährt, wenn mehrere Schleusenstufen in Bandlaufrichtung hintereinander angeordnet sind.

Die Bandschleuse wird bevorzugt eingesetzt, um zur Abdichtung eines ersten Raumes mit einem ersten Druckniveau gegenüber einem zweiten Raum mit einem zweiten, vom ersten Druckniveau abweichenden Druckniveau zu dienen. Sie kann aber auch bei Druckgleichheit der Räume eingesetzt werden, wenn in diesen unterschiedliche Medien gegeneinander abgedichtet werden müssen; in diesem Falle ist also vorgesehen, dass die Bandschleuse zur Abdichtung eines ersten Raumes mit einem ersten Prozessmedium gegenüber einem zweiten Raum mit einem zweiten, vom ersten Prozessmedium verschiedenen Prozessmedium eingesetzt wird.

In der Zeichnung sind Ausführungsbeispiele der Erfindung dargestellt. Es zeigen:
- Fig. 1: schematisch die Seitenansicht eines Prozessbereichs zur Behand- lung eines Stahlbandes mit Bandschleusen,
- Fig. 2: die Draufsicht auf ein Band, das durch den Prozessbereich gemäß Fig. 1 abgedichtet durch Bandschleusen hindurchgeführt werden soll,
- Fig. 3: zwei zusammenwirkende Rollen zur Abdichtung des Bandes, in För- derrichtung des Bandes gesehen,
- Fig. 4: eine Rolle zur Abdichtung im Schnitt A-B gemäß Fig. 3, dargestellt ohne Mantel aus elastischem Material,
- Fig. 5: eine Ausführungsform zweier Abdichtrollen, die sich an ein Band an- legen, wobei die Rollen einmal in Förderrichtung gesehen und einmal in Achsrichtung der Rollen gesehen dargestellt sind,
- Fig. 6: eine alternative Ausführungsform zweier Abdichtrollen, in der Dar- stellung gemäß Fig. 5,
- Fig. 7: in schematischer Darstellung eine erste Ausführung einer Rolle samt Mantel aus elastischem Material,
- Fig. 8: in schematischer Darstellung eine zweite Ausführung einer Rolle samt Mantel aus elastischem Material,
- Fig. 9: in schematischer Darstellung eine dritte Ausführung einer Rolle samt Mantel aus elastischem Material,
- Fig. 10: eine zu Fig. 9 analoge Darstellung einer Rolle samt Mantel aus elas- tischem Material mit einigen Details,
- Fig. 11: eine Rolle oberhalb des abzudichtenden Bandes mit einer hinter ihr angeordneten Abdichtrolle, in Achsrichtung der Rolle gesehen,
- Fig. 12: eine zu Fig. 11 alternative Ausführung der Rolle mit zwei hinter ihr angeordneten Abdichtrollen, in Achsrichtung der Rolle gesehen,
- Fig. 13a: eine Rolle samt Anordnung zur seitlichen Abdichtung derselben, in Achsrichtung betrachtet und
- Fig. 13b: die zu Fig. 13a zugehörige Draufsicht,
- Fig. 14: schematisch die Darstellung einer Bandschleuse mit mehreren Schleusenstufen,
- Fig. 15a: eine Anordnung zur seitlichen Abdichtung des Bandes in Förderrich- tung des Bandes gesehen,
- Fig. 15b: die Anordnung zur seitlichen Abdichtung gemäß Fig. 15a in Achsrich- tung der Rolle gesehen und
- Fig. 15c: die Draufsicht auf die Anordnung zur seitlichen Abdichtung gemäß Fig. 15a.

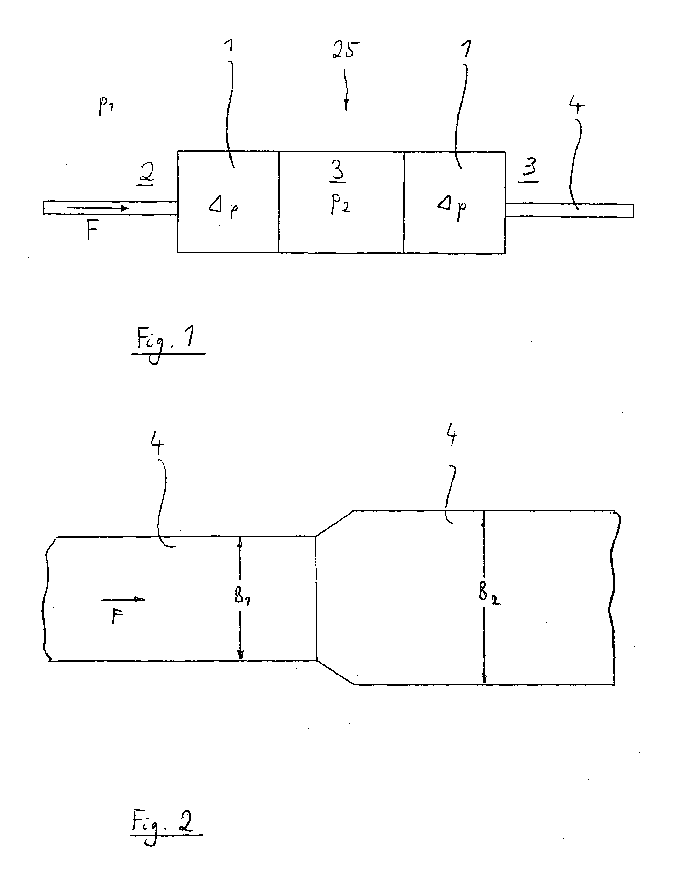

In Fig. 1 ist ein Prozessbereich 25 zu sehen, durch den ein Band 4 in Förderrichtung F kontinuierlich hindurchgeführt werden soll. Im Prozessbereich 25 wirkt ein zweiter Druck p₂, der gegenüber dem Umgebungsdruck p₁ (erster Druck) reduziert ist. Um die Druckdifferenz Δp zwischen den beiden Drücken auch im kontinuierlichen Betrieb aufrecht zu erhalten, befindet sich in Förderrichtung F vor und hinter dem Prozessbereich 25 je eine Bandschleuse 1. Die Umgebung stellt also einen ersten Raum 2 und der Prozessbereich 25 einen zweiten Raum 3 dar, in denen unterschiedliche Drücke herrschen. Zur Herstellung der Abdichtung weist jede Bandschleuse 1 mindestens zwei Rollen auf, die nachfolgend näher erläutert sind.

Das Band 4 muss möglichst kontinuierlich durch die Behandlungsanlage geführt werden. Hierzu werden Bandcoils am Bandanfang bzw. am Bandende durch Schweißen miteinander verbunden. Dabei kann sich, wie es in Fig. 2 zu sehen ist, die Breite und/oder Dicke des Bandes 4 an der Verbindungsstelle mehr oder weniger stetig ändern. Das in Förderrichtung F vordere Band 4 hat im Ausführungsbeispiel gemäß Fig. 2 eine größere Breite B₂ als das nachfolgende Band 4, das eine Breite B₁ aufweist. Wie dargstellt ist, kann eine Kantenabschrägung einen kontinuierlichen Übergang ermöglichen.

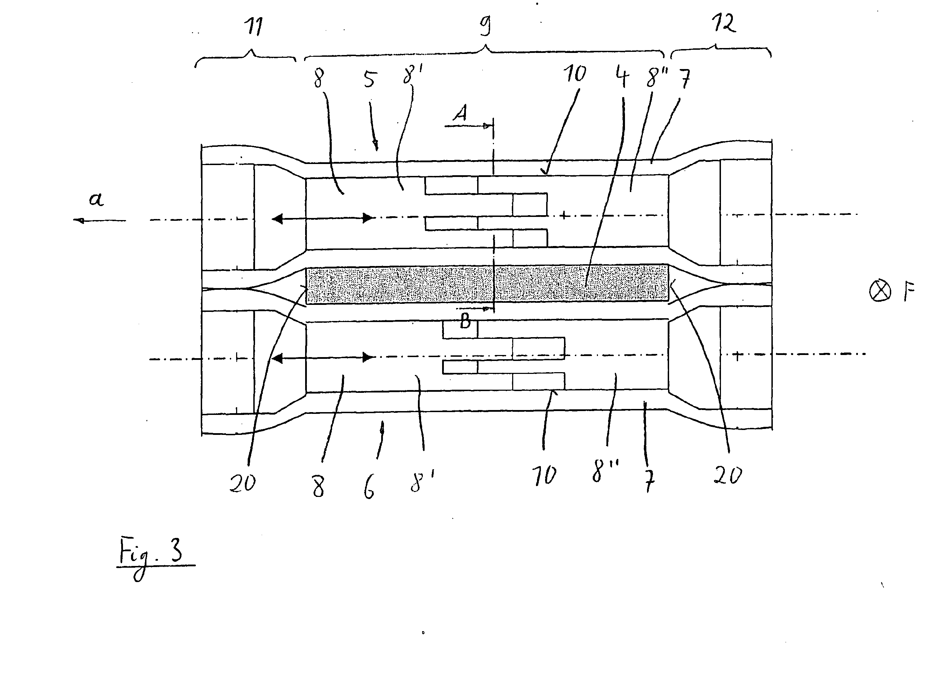

Um Rollen zur Abdichtung des Bandes 4 in verbesserter Weise für Produkte mit variabler Dicke und/oder Breite tauglich zu machen, ist eine Ausgestaltung der Rollen vorgesehen, wie sie in Fig. 3 dargestellt sind.

Hier ist zunächst das Band 4 dargestellt, und zwar in Förderrichtung F gesehen. Zur Abdichtung liegt eine Rolle 5 an der Oberseite des Bandes 4 und eine Rolle 6 an der Unterseite des Bandes 4 an. Jede Rolle 5, 6 hat einen Kern 8 aus Stahl der von einem Mantel aus flexiblem, elastischem Material 7 umgeben ist. Während der Kern 8 in einem Mittenbereich 9 eine zylindrische Außenkontur 10 aufweist, ist er an seinen Seitenbereichen 11 und 12 radial aufgeweitet, wobei vorliegend an einen konischen Teil ein ganz außen angeordneter zylindrischer Bereich angrenzt.

Durch den radial aufgeweiteten Randbereich des Kerns 8 und damit auch des Material 7 wird im Randbereich des Rollen 5, 6 eine verbesserte Dichtwirkung erreicht.

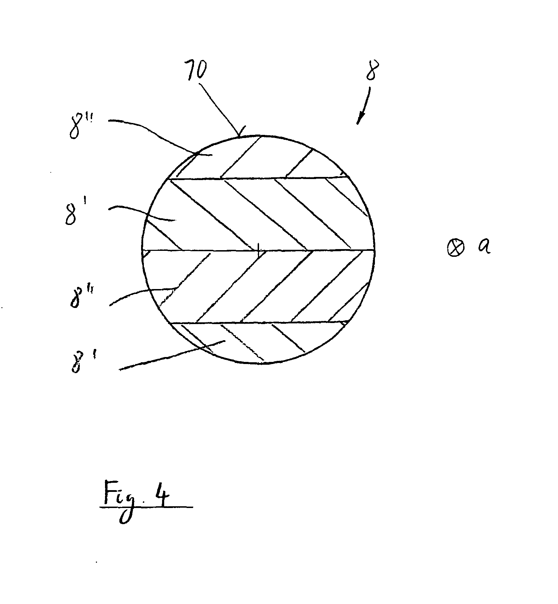

Damit dies auch bei Bändern 4 verschiedener Breite optimal genutzt werden kann, besteht der Kern 8 aus zwei Teilen 8' und 8", die in Achsrichtung a zueinander verschiebbar sind. Dabei sind die beiden Teile 8', 8" an ihrer Kontaktstelle so ausgeführt, dass sie im Querschnitt eine komplementäre Form aufweisen, wie es aus Fig. 4 hervorgeht.

Mit dieser Ausgestaltung ist es möglich, die Rollen 5, 6 mit nicht dargestellten Betätigungsmitteln in Achsrichtung a auseinanderzuziehen oder zusammenzuschieben, um die axiale Länge der zylindrischen Bereiche 10 des Kerns 8 an die tatsächliche Bandbreite anzupassen. Damit wird erreicht, dass bei Bändern unterschiedlicher Breite ein optimaler Dichteffekt durch die Rollen 5, 6 erzielt wird.

Die Kerne 8 sind also mit dem Mantel aus flexiblem Material 7 bezogen, wobei dieser radial dehnbar ist. Die Breitenanpassung an die Breite des Bandes 4 erfolgt durch Ineinanderschieben bzw. Auseinanderziehen des Kerns 8 in axiale Richtung a. Die Banddickenanpassung erfolgt mittels Stellgliedern (z. B. Spreizdornen) unterhalb des elastischen Materials 7.

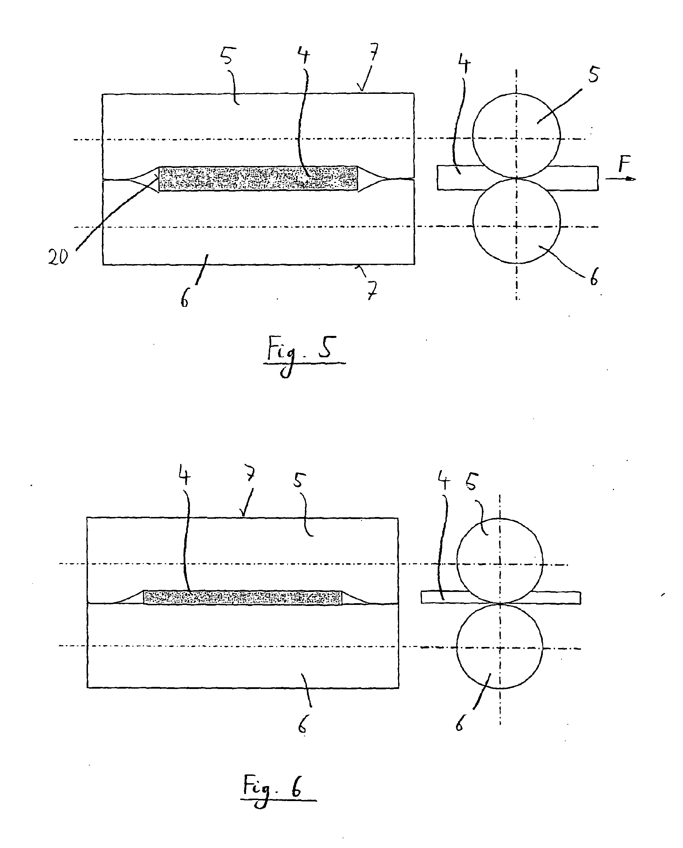

In Fig. 5 ist nochmals das Prinzip der Anordnung gemäß Fig. 3 zu sehen, d. h. die beiden Rollen 5, 6, die jeweils einen Mantel aus elastischem Material 7 aufweisen und sich an das Band 4 so anlegen, dass es optimal abgedichtet ist. Lediglich im Bereich der Bandkante 20 bleibt ein Zwickel offen, der umso kleiner ist, je elastischer das Material 7 ist.

Das Band 4 bettet sich also in das elastische Material 7 ein. Die Bereiche seitlich des Bandes werden direkt durch den Kontakt der Rollenmäntel gedichtet. Die Flexibilität des Materials 7 ermöglicht die Abdichtung unterschiedlicher Banddicken im typischen Arbeitsbereich ohne Nachstellen der Rollen.

Möglich ist es jedoch auch, dass nur eine Rolle 5 so ausgeführt ist und mit einer Rolle 6 zusammenwirkt, die beispielsweise einen Stahlmantel aufweist, der keine Elastizität an seinem Außenumfang hat. Dies ist in Fig. 6 zu sehen. Die Anlage des elastischen Materials 7 ergibt sich hier wie dargestellt.

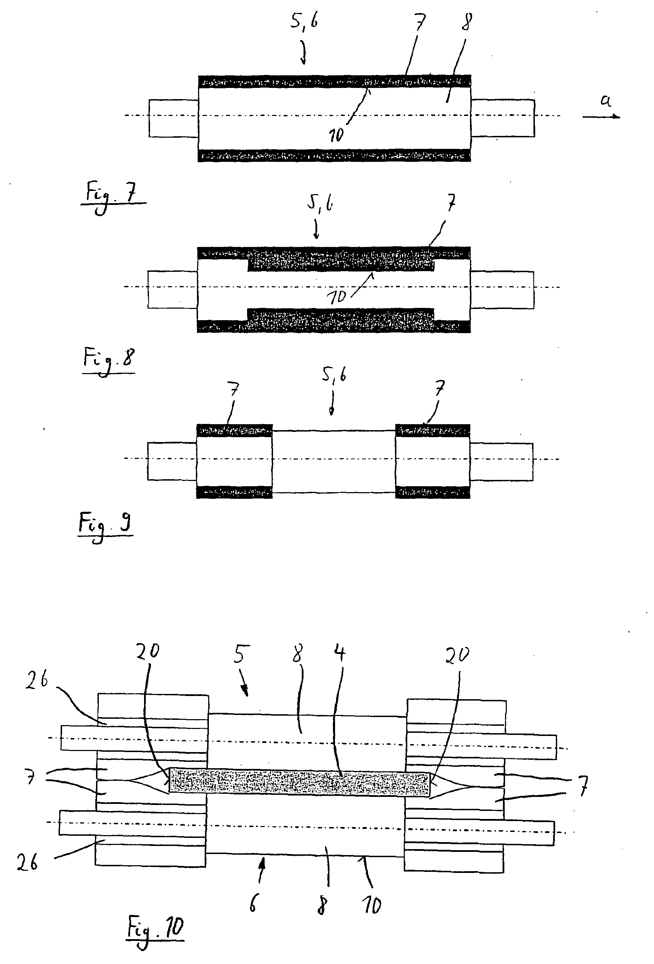

In den Figuren 7, 8 und 9 sind schematisch verschiedene Ausgestaltungen der Rolle 5, 6 zu sehen.

In Fig. 7 weist der Mantel aus elastischem Material 7 über die gesamte Erstreckung der Rolle 5, 6 in Achsrichtung a eine konstante Dicke auf; die hier angedeutete zylindrische Kontur 10 der Rolle 5, 6 ist über die gesamte Rollenbreite konstant.

Gemäß der Lösung nach Fig. 8 ist die zylindrische Kontur 10 des Kerns 8 im Mittenbereich der Rolle 5, 6 im Durchmesser zugunsten eines hier dickeren Mantels aus elastischem Material 7 reduziert.

Bei der Lösung gemäß Fig. 9 ist elastisches Material 7 nur in den Randbereichen der Rolle 5, 6 angeordnet, da letztlich hier die kritische Stelle der Abdichtung (im Bereich der Bandkante) liegt.

Die Lösung gemäß Fig. 9 ist in Fig. 10 noch einmal detaillierter dargestellt. Zu sehen ist hier, dass die Mäntel aus elastischem Material 7 über Hülsen 26 auf den Kernen 8 gelagert sind. Der zylindrische Mittenbereich 10 ist kleiner ausgeführt als die minimale Bandbreite. Die Mäntel aus elastischem Material 7 decken immer die Bandkante 20 ab. Mittels der Hülsen 26 sind die Mäntel aus flexiblem Material 7 einfach auswechselbar.

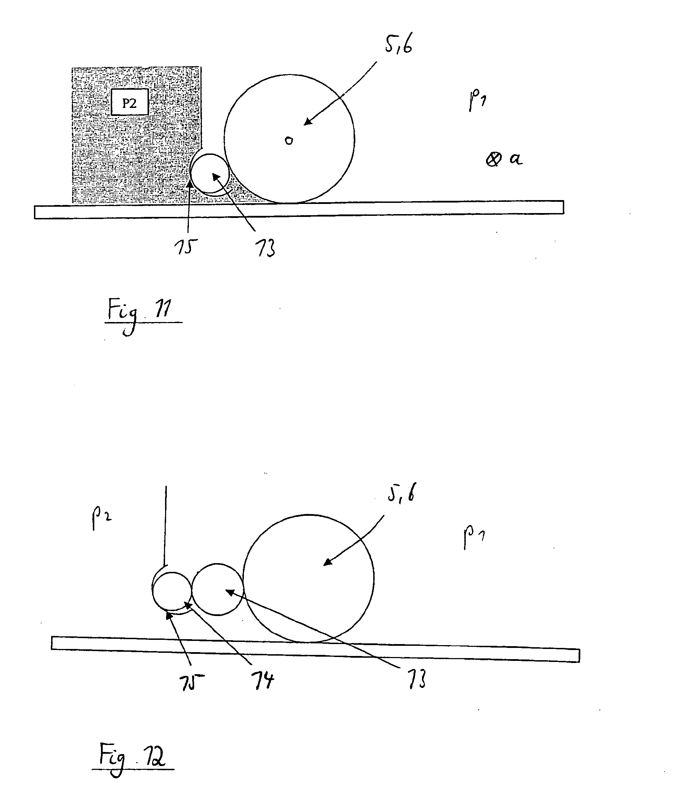

In Fig. 11 ist zu sehen, wie eine Rückraumabdichtung der Bandschleuse 1 bewerkstelligt werden kann. Die Rolle 5, 6 liegt hier an einer Abdichtrolle 13 an, die sich gleich lang in Achsrichtung a erstreckt wie die Rolle 5, 6. Die Abdichtrolle 13 wiederum läuft an einer Dichtfläche 15 an, die - der Form der Abdichtrolle 13 entsprechend - eine konkave Anlauffläche aufweist. Diese Anlauffläche stellt eine Gleitfläche bzw. ein Gleitlager dar.

An die den Prozessraum abdichtende Rolle 5, 6 wird also eine feste Abdichtrolle 13 gedrückt. Diese bildet in Kombination mit der stützenden Gleitfläche 15 die Abdichtung im Rückraumbereich. Diese Dichtung arbeitet auch beim Einsatz des flexiblen Materials 7; die Abdichtrolle 13 wird in den Mantel aus flexiblem Material 7 entsprechend eingedrückt.

In Fig. 12 ist zu sehen, dass dieses Prinzip auch entsprechend genutzt werden kann, wenn zwei Abdichtrollen 13 und 14 eingesetzt werden. Die Abdichtrolle 13 kann hier als flexible Abdichtrolle ausgeführt sein. Diese wird von einer festen Abdichtrolle 14 auf der Rückseite abgedichtet. Die Abdichtrolle 14 bildet in Kombination mit der stützenden Gleitfläche 15 die Abdichtung im Rückraumbereich.

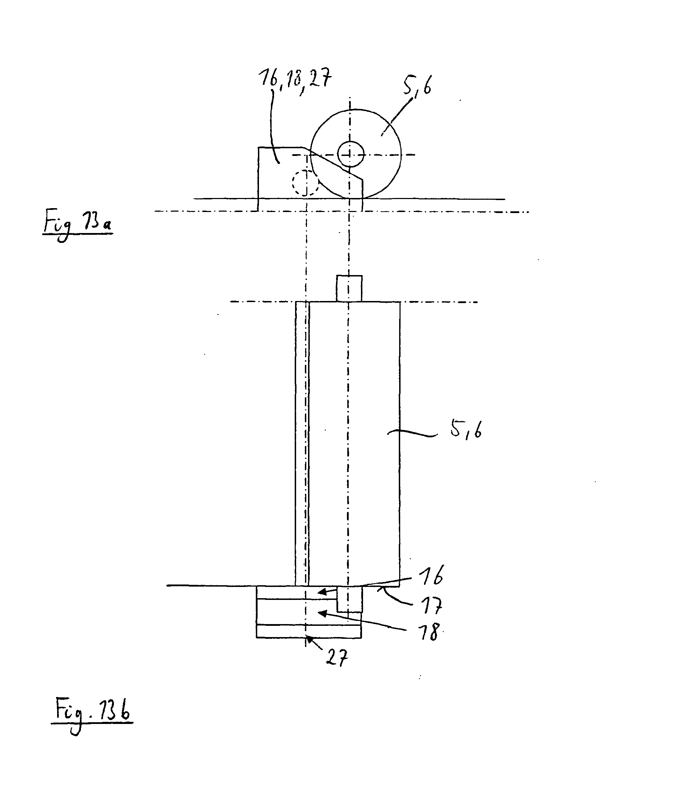

Die seitliche Abdichtung kann mittels Druckstücken bzw. Dichtplatten erfolgen, wie es in Fig. 13a und 13b dargestellt ist.

Die seitliche Abdichtung erfolgt über ein flexibles Dichtelement 16, das vorliegend als Dichtplatte ausgeführt ist. Das Dichtelement 16 dichtet die Stirnseite 17 der Rolle 5, 6 ab. Zur besseren Dichtwirkung wirkt zwischen einer ortsfesten Gegenplatte 27 und dem Dichtelement 16 ein Federelement 18, das das Dichtelement 16 in axiale Richtung a gegen die Stirnseite 17 der Rolle 5, 6 drückt. Das Federelement 18 kann beispielsweise eine Bürste oder Schaumstoff sein.

Im Falle der Abdichtung des Rückraumes mit Abdichtrollen erfolgt gegebenenfalls die Durchführung der Wellenzapfen bzw. Druckstücke zur axialen Abstützung der Dichtrollen durch den seitlichen Abdichtbereich. Alternativ kann ein festes Druckstück im Dichtrollenbereich von außen auf das Dichtelement 16 aufgesetzt werden.

Durch die axiale Abstützung soll das Abheben des Dichtelements 16 bei auftretenden Axialkräften an der Abdichtrolle und die damit verbundene Leckage vermieden werden.

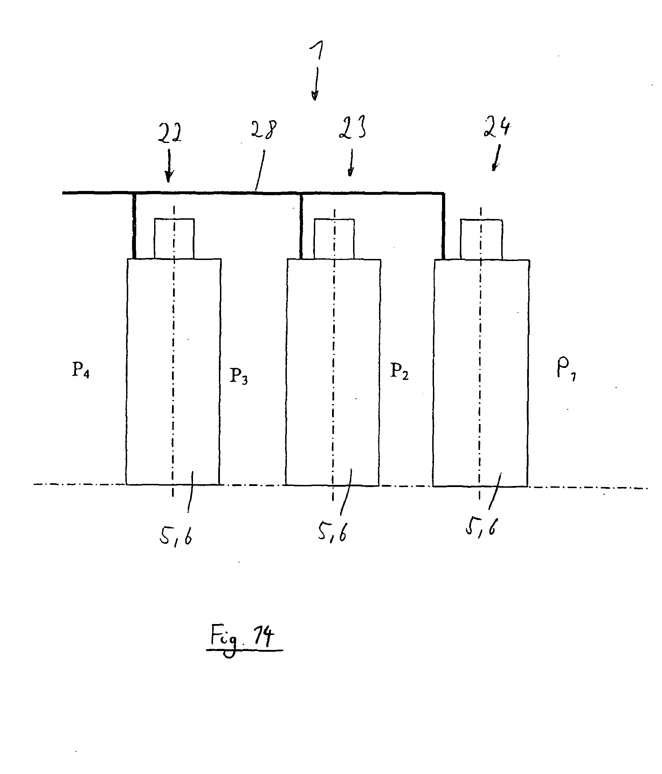

In Fig. 14 ist zu sehen, dass mehrere Schleusenstufen 22, 23, 24 vorgesehen werden können, um jeweilige Druckdifferenzen innerhalb einer Kammerbegrenzung 28 aufzubauen und so den Druck allmählich entlang der Bandschleuse 1 auf- bzw. abzubauen.

Der Druck steigt bzw. fällt allmählich vom Druck p₁ über den Druck p₂ und den Druck p₃ bis zum Druck p₄. Hier ist also ein Kaskadenaufbau gewählt, um den Druck von Schleusenstufe zu Schleusenstufe ab- bzw. abzubauen. Daraus folgt, dass sich die maximal abzudichtende Druckdifferenz im Rollenbereich immer nur auf die im Prozessbereich der aktuellen Schleusenstufe abzudichtenden Druckdifferenz bezieht.

Die Folge ist eine Reduzierung des abzupumpenden Leckagevolumens.

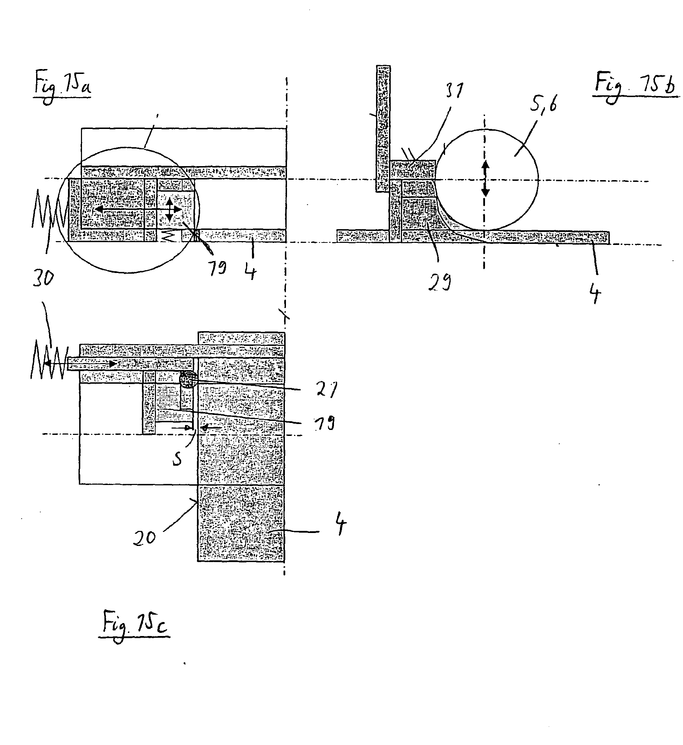

In Fig. 15a, 15b und 15c ist schließlich ein weiteres Abdichtsystem für eine Bandschleuse dargestellt, die sich vor allem für Bänder mit variabler Dicke und Breite eignet.

Die Abdichtung im Bereich der Bandkante 20 erfolgt über die dargestellte Vorrichtung. Zur Anpassen der Vorrichtung an die aktuelle Bandbreite erfolgt ein Vorpositionieren des seitlichen Dichtelements 19. Für die Rückraumabdichtung ist ein weiteres Dichtelement 29 vorgesehen.

Die Anpassung an kleine Änderungen der Bandbreite bzw. der Bandlage erfolgt durch die Wirkung eines Federelements 30. Um das Dichtelement 19 vor Verschleiß zu schützen, ist eine auf der Bandkante 20 laufende Führungsrolle 21 vorgesehen, die einen kleinen Spaltabstand s des Dichtelements 19 zur Bandkante 20 einhält.

Die Abdichtung im Bandkantenbereich wird also über ein mehrteiliges Dichtsystem erreicht. Das federbelastete und verschiebbare Dichtelement 19 (Gleitstück) passt sich selbstständig an die vorhandene Rollenanstellung an. Die Abdichtung der Rolle 5, 6 erfolgt im Rückraumbereich durch eine Dichtleiste 31 im Reibkontakt.

Mit der vorgeschlagenen Lösung können Räume unterschiedlichen Ducks, aber auch Räume gleichen Drucks gegeneinander abgedichtet werden, in denen sich verschiedenen Prozessmedien, insbesondere Prozessgase, aber auch Flüssigkeiten, befinden. Sofern seitliche Rollen vorgesehen werden, die an der Bandkante anlaufen, kann mit diesen eine gute seitliche Führung des Bandes erreicht werden. Auf der Bandoberfläche laufende Rollen können zur Führung von Blendenelementen genutzt werden.

### Bezugszeichenliste:

- 1: Bandschleuse
- 2: erster Raum
- 3: zweiter Raum
- 4: Band
- 5: Rolle
- 6: Rolle
- 7: flexibles, elastisches Material
- 8: innerer Kern
- 8': Teil des Kerns
- 8": Teil des Kerns
- 9: Mittenbereich
- 10: zylindrische Kontur
- 11: Randbereich
- 12: Randbereich
- 13: Abdichtrolle
- 14: Abdichtrolle
- 15: Dichtfläche
- 16: Dichtelement
- 17: Stirnseite der Rolle
- 18: Federelement
- 19: Dichtelement
- 20: Bandkante
- 21: Führungsrolle
- 22: Schleusenstufe
- 23: Schleusenstufe
- 24: Schleusenstufe
- 25: Prozessbereich
- 26: Hülse
- 27: Gegenplatte
- 28: Kammerbegrenzung
- 29: Dichtelement
- 30: Federelement
- 31: Dichtleiste

- p₁: erstes Druckniveau
- p₂: zweites Druckniveau
- p₃: weiteres Druckniveau
- p₄: weiteres Druckniveau
- Δp: Druckdifferenz
- F: Förderrichtung
- a: Achsrichtung
- s: Spaltabstand
- B₁: Bandbreite
- B₂: Bandbreite

## Patentansprüche

1. Bandschleuse (1) zur Abdichtung eines ersten Raumes (2) gegenüber einem zweiten Raum (3), wobei beide Räume (2, 3) von einem Band (4), insbesondere einem Metallband, passiert werden, wobei zur Abdichtung der Räume (2, 3) mindestens zwei Rollen (5, 6) vorgesehen sind, die sich beidseitig des Bandes (4) dichtend an dieses anlegen,
**dadurch gekennzeichnet,**
**dass** mindestens eine der Rollen (5, 6) an ihrem Umfang zumindest abschnittsweise mit einem flexiblen, elastischen Material (7) versehen ist, wobei die mindestens eine Rolle (5, 6) einen inneren Kern (8) aufweist, der mit einem Mantel aus dem flexiblen, elastischen Material (7) versehen ist, wobei der innere Kern (8) in einem Mittenbereich (9) eine zylindrische Kontur (10) aufweist und wobei der Kern (8) in seinen Randbereichen (11, 12) radial aufgeweitet ist, so dass auch die Rolle (5, 6) in den Randbereichen (11, 12) gegenüber dem Mittenbereich (9) radial aufgeweitet ist.

2. Bandschleuse nach Anspruch 1,
**dadurch gekennzeichnet,**
**dass** der Kern (8) aus zwei Teilen (8', 8") besteht, die in Achsrichtung (a) zueinander verschiebbar sind.

3. Bandschleuse nach Anspruch 1 oder 2,
**dadurch gekennzeichnet,**
**dass** eine der zusammenwirkenden Rollen (5, 6) eine über die gesamte axiale Erstreckung durchgängige zylindrische Kontur mit konstantem Durchmesser aufweist.

4. Bandschleuse nach Anspruch 3,
**dadurch gekennzeichnet,**
**dass** die Oberfläche der mit durchgängig zylindrischer Kontur versehenen Rolle (5, 6) aus Stahl besteht.

5. Bandschleuse nach Anspruch 3,
**dadurch gekennzeichnet,**
**dass** die mit durchgängig zylindrischer Kontur versehene Rolle (5, 6) mit flexiblem, elastischem Material (7) versehen ist.

6. Bandschleuse nach Anspruch 1 oder 2,
**dadurch gekennzeichnet,**
**dass** beide zusammenwirkenden Rollen (5, 6) den inneren Kern (8) mit der in den Randbereichen (11, 12) aufgeweiteten Kontur aufweisen.

7. Bandschleuse nach einem der Ansprüche 2 bis 6,
**dadurch gekennzeichnet,**
**dass** die beiden zueinander axial verschieblichen Teile (8', 8") in ihrem Berührungsbereich eine zueinander komplementäre Querschnittsform haben.

8. Bandschleuse nach einem der Ansprüche 1 bis 7,
**dadurch gekennzeichnet,**
**dass** die mindestens eine Rolle (5, 6) über ihre gesamte axiale Erstreckung mit dem Mantel aus flexiblem, elastischem Material (7) versehen ist.

9. Bandschleuse nach einem der Ansprüche 1 bis 7,
**dadurch gekennzeichnet,**
**dass** die mindestens eine Rolle (5, 6) nur in ihren axialen Randbereichen mit einem Mantel aus flexiblem, elastischem Material (7) versehen ist.

10. Bandschleuse nach einem der Ansprüche 1 bis 9,
**dadurch gekennzeichnet,**
**dass** die mindestens eine Rolle (5, 6) an mindestens einer Abdichtrolle (13) anläuft, die auf derselben Bandseite angeordnet ist.

11. Bandschleuse nach Anspruch 10,
**dadurch gekennzeichnet,**
**dass** die Abdichtrolle (13) an einer weiteren Abdichtrolle (14) anläuft.

12. Bandschleuse nach Anspruch 10 oder 11,
**dadurch gekennzeichnet,**
**dass** zumindest eine der Abdichtrollen (13, 14) an einer Dichtfläche (15) anläuft.

13. Bandschleuse nach Anspruch 12,
**dadurch gekennzeichnet,**
**dass** die Dichtfläche (15) konkav ausgebildet ist, insbesondere der Form der sie kontaktierenden Abdichtrolle (13, 14) angepasst ist.

14. Bandschleuse nach einem der Ansprüche 1 bis 13,
**dadurch gekennzeichnet,**
**dass** im axialen Endbereich der mindestens einen Rolle (5, 6) ein Dichtelement (16) angeordnet ist, das die Stirnseite (17) der mindestens einen Rolle (5, 6) kontaktiert.

15. Bandschleuse nach Anspruch 14,
**dadurch gekennzeichnet,**
**dass** das Dichtelement (16) so angeordnet ist, dass es mittels eines Federelements (18) in axiale Richtung (a) elastisch vorgespannt an der Stirnseite (17) der mindestens einen Rolle (5, 6) anliegt.

16. Bandschleuse nach einem der Ansprüche 1 bis 13,
**dadurch gekennzeichnet,**
**dass** im axialen Endbereich der mindestens einen Rolle (5, 6) ein Dichtelement (19) angeordnet ist, das über eine seitliche, an der Bandkante (20) anlaufende Führungsrolle (21) auf einem definierten Spaltabstand (s) zur Bandkante (20) gehalten wird.

17. Bandschleuse nach einem der Ansprüche 1 bis 16,
**dadurch gekennzeichnet,**
**dass** mehrere Schleusenstufen (22, 23, 24) in Bandlaufrichtung hintereinander angeordnet sind.

18. Bandschleuse nach einem der Ansprüche 1 bis 17,
**dadurch gekennzeichnet,**
**dass** sie zur Abdichtung eines ersten Raumes (2) mit einem ersten Druckniveau (p₁) gegenüber einem zweiten Raum (3) mit einem zweiten, vom ersten Druckniveau abweichenden Druckniveau (p₂) eingesetzt wird.

19. Bandschleuse nach einem der Ansprüche 1 bis 17,
**dadurch gekennzeichnet,**
**dass** sie zur Abdichtung eines ersten Raumes (2) mit einem ersten Prozessmedium gegenüber einem zweiten Raum (3) mit einem zweiten, vom ersten Prozessmedium verschiedenen Prozessmedium eingesetzt wird.

## Claims

1. Strip-sealing gate (1) for sealing a first space (2) relative to a second space (3), wherein a strip (4), particularly a metal strip, passes through both spaces (2, 3) and wherein provided for sealing these spaces (2, 3) are at least two rollers (5, 6) which sealingly bear against the strip (4) at both sides thereof, **characterised in that** at least one of the rollers (5, 6) is provided at its circumference at least in sections with a flexible resilient material (7), wherein the at least one roller (5, 6) has an inner core (8) provided with a casing of the flexible resilient material (7), wherein the inner core (8) has a cylindrical profile (10) in a centre region (9) and wherein the core (8) is radially widened in its edge regions (11, 12) so that the roller (5, 6) is also radially widened in the edge regions (11, 12) relative to the centre region (9).

2. Strip-sealing gate according to claim 1, **characterised in that** the core (8) consists of two parts (8', 8") which are displaceable relative to one another in axial direction (a).

3. Strip-sealing gate according to claim 1 or 2, **characterised in that** one of the cooperating rollers (5, 6) has a cylindrical profile, which is continuous over the entire axial length, with constant diameter.

4. Strip-sealing gate according to claim 3, **characterised in that** the surface of the roller (5, 6) provided with the continuous cylindrical contour consists of steel.

5. Strip-sealing gate according to claim 3, **characterised in that** the roller (5, 6) provided with the continuous cylindrical contour is provided with flexible resilient material (7).

6. Strip-sealing gate according to claim 1 or 2, **characterised in that** the two cooperating rollers (5, 6) have the inner core (8) with the profile widened in the edge regions (11, 12).

7. Strip-sealing gate according to any one of claims 2 to 6, **characterised in that** the two parts (8', 8") axially displaceable relative to one another have a mutually complementary cross-sectional shape in their contact region.

8. Strip-sealing gate according to any one of claims 1 to 7, **characterised in that** at least one roller (5, 6) is provided over its entire axial length with the casing of flexible resilient material (7).

9. Strip-sealing gate according to any one of claims 1 to 7, **characterised in that** the at least one roller (5, 6) is provided with a casing of flexible resilient material (7) only in its axial edge regions.

10. Strip-sealing gate according to any one of claims 1 to 9, **characterised in that** the at least one roller (5, 6) runs against at least one sealing roller (13), which is arranged on the same strip side.

11. Strip-sealing gate according to claim 10, **characterised in that** the sealing roller (13) runs against a further sealing roller (14).

12. Strip-sealing gate according to claim 10 or 11, **characterised in that** at least one of the sealing rollers (13, 14) runs against a sealing surface (15).

13. Strip-sealing gate according to claim 12, **characterised in that** the sealing surface (15) is of concave construction, in particular is matched to the shape of the sealing roller (13, 14) in contact therewith.

14. Strip-sealing gate according to any one of claims 1 to 13, **characterised in that** a sealing element (16) is arranged in the axial edge region of the at least one roller (5, 6) and contacts the end face (17) of the at least one roller (5, 6).

15. Strip-sealing gate according to claim 14, **characterised in that** the sealing element (16) is so arranged that it bears against the end face (17) of the at least one roller (5, 6) under resilient bias in axial direction (a) by means of a spring element (18).

16. Strip-sealing gate according to any one of claims 1 to 13, **characterised in that** a sealing element (19) is arranged in the axial end region of the at least one roller (5, 6) and is kept at a defined gap spacing (s) from the strip edge (20) by way of a lateral guide roller (21) running against the strip edge (20).

17. Strip-sealing gate according to any one of claims 1 to 16, **characterised in that** several strip-sealing gates (22, 23, 24) are arranged in succession in strip running direction.

18. Strip-sealing gate according to any one of claims 1 to 17, **characterised in that** it is used for sealing a first space (2) with a first pressure level (p₁) relative a second space (3) with a pressure level (p₂) differing from the first pressure level.

19. Strip-sealing gate according to any one of claims 1 to 17, **characterised in that** it is used for sealing a first space (2) with a first process medium relative to a second space (3) with a second process medium differing from the first process medium.

## Revendications

1. Joint (1) pour bande pour fermer un premier espace (2) par rapport à un deuxième espace (3), les deux espaces (2, 3) étant traversés par une bande (4), en particulier une bande métallique, où on a prévu, pour la fermeture des espaces (2, 3) au moins deux rouleaux (5, 6) qui se placent de manière étanche contre les deux faces de la bande (4) **caractérisé**
**en ce qu'**au moins un des deux rouleaux (5, 6) est pourvu, sur sa périphérie, au moins par sections, d'un matériau souple élastique (7), ledit au moins un rouleau (5, 6) présentant un noyau interne (8), qui est pourvu d'une enveloppe en un matériau élastique souple (7), le noyau interne (8) présentant dans une zone centrale (9) un contour cylindrique (10), le noyau (8) étant élargi radialement dans ses zones de bord (11, 12) de manière telle que le rouleau (5, 6) est également élargi radialement dans les zones de bord (11, 12) par rapport à la zone centrale (9).

2. Joint pour bande selon la revendication 1, **caractérisé en ce que** le noyau (8) est constitué par deux parties (8', 8") qui peuvent être déplacées l'une par rapport à l'autre dans le sens axial (a).

3. Joint pour bande selon la revendication 1 ou 2, **caractérisé en ce qu'**un des rouleaux (5, 6) qui interagissent présente, un contour cylindrique continu sur toute l'étendue axiale, d'un diamètre constant.

4. Joint pour bande selon la revendication 3, **caractérisé en ce que** la surface du rouleau (5, 6) pourvu du contour cylindrique continu est en acier.

5. Joint pour bande selon la revendication 3, **caractérisé en ce que** le rouleau (5, 6) pourvu du contour cylindrique continu est pourvu d'un matériau souple, élastique (7).

6. Joint pour bande selon la revendication 1 ou 2, **caractérisé en ce que** les deux rouleaux (5, 6) qui interagissent présentent le noyau interne (8) avec le contour élargi dans les zones de bord (11, 12).

7. Joint pour bande selon l'une quelconque des revendications 2 à 6, **caractérisé**
**en ce que** les deux parties (8', 8") pouvant être déplacées axialement l'une par rapport à l'autre présentent, dans leur zone de contact, une forme de section transversale complémentaire l'une à l'autre.

8. Joint pour bande selon l'une quelconque des revendications 1 à 7, **caractérisé**
**en ce que** ledit au moins un rouleau (5, 6) est pourvu sur toute son étendue axiale de l'enveloppe en matériau souple, élastique (7).

9. Joint pour bande selon l'une quelconque des revendications 1 à 7, **caractérisé**
**en ce que** ledit au moins un rouleau (5, 6) n'est pourvu que dans ses zones de bord axiales d'une enveloppe en matériau souple, élastique (7).

10. Joint pour bande selon l'une quelconque des revendications 1 à 9, **caractérisé**
**en ce que** ledit au moins un rouleau (5, 6) frotte au moins contre un rouleau d'étanchéité (13) qui est disposé sur la même face de la bande.

11. Joint pour bande selon la revendication 10, **caractérisé en ce que** le rouleau d'étanchéité (13) frotte contre un autre rouleau d'étanchéité (14).

12. Joint pour bande selon la revendication 10 ou 11, **caractérisé en ce qu'**au moins un des rouleaux d'étanchéité (13, 14) frotte contre une surface d'étanchéité (15).

13. Joint pour bande selon la revendication 12, **caractérisé en ce que** la surface d'étanchéité (15) présente une forme concave, en particulier adaptée à la forme du rouleau d'étanchéité (13, 14) avec lequel elle est en contact.

14. Joint pour bande selon l'une quelconque des revendications 1 à 13, **caractérisé**
**en ce que** dans la zone d'extrémité axiale dudit au moins un rouleau (5, 6) est disposé un élément d'étanchéité (16) qui est en contact avec la face frontale (17) dudit au moins un rouleau (5, 6).

15. Joint pour bande selon la revendication 14, **caractérisé en ce que** l'élément d'étanchéité (16) est disposé de manière telle qu'il se place au moyen d'un élément à ressort (18) élastiquement précontraint dans le sens axial (a) contre la face frontale (17) dudit au moins un rouleau (5, 6).

16. Joint pour bande selon l'une quelconque des revendications 1 à 13, **caractérisé**
**en ce que** dans la zone d'extrémité axiale dudit au moins un rouleau (5, 6) est disposé un élément d'étanchéité (19) qui est en maintenu via un rouleau de guidage (21) latéral frottant contre le bord de la bande (20) à une distance de fente (s) définie par rapport au bord de la bande (20).

17. Joint pour bande selon l'une quelconque des revendications 1 à 16, **caractérisé**
**en ce que** plusieurs étages (22, 23, 24) de joint sont placés les uns derrière les autres dans le sens de transport de la bande.

18. Joint pour bande selon l'une quelconque des revendications 1 à 17, **caractérisé**
**en ce qu'**il est utilisé pour fermer un première espace (2) présentant un premier niveau de pression (p₁) par rapport à un deuxième espace (3) présentant un deuxième niveau de pression (p₂) différent du premier niveau de pression.

19. Joint pour bande selon l'une quelconque des revendications 1 à 17, **caractérisé**
**en ce qu'**il est utilisé pour fermer un premier espace (2) présentant un premier agent de procédé par rapport à un deuxième espace (3) présentant un deuxième agent de procédé différent du premier agent de procédé.
